# EUROPEAN PATENT APPLICATION

(11) **EP 4 231 119 A1**
(43) Date of publication of application: **23.08.2023**
(21) Application number: 21906943.2
(22) Date of filing: 02.12.2021
(51) Int. Cl.: G06F 1/20, G06F 1/16, H05K 7/20, H05K 1/11, H05K 5/00

(54) **ELECTRONIC DEVICE COMPRISING HEAT DISSIPATING MEMBER**

(30) Priority: 16.12.2020 KR 20200176556
(71) Applicant: Samsung Electronics Co., Ltd., Suwon-si, Gyeonggi-do 16677 (KR)
(72) Inventor: JUNG, Chunghyo, Suwon-si, Gyeonggi-do 16677 (KR); PARK, Hyein, Suwon-si, Gyeonggi-do 16677 (KR); LIM, Jaedeok, Suwon-si, Gyeonggi-do 16677 (KR); KOO, Kyungha, Suwon-si, Gyeonggi-do 16677 (KR); MOON, Hongki, Suwon-si, Gyeonggi-do 16677 (KR)
(74) Representative: HGF
(86) International application number: PCT/KR2021/018138
(87) International publication number: WO 2022/131638

(57) **Abstract**

Disclosed is an electronic device comprising: a first heat dissipating part plated on the front surface of a rear case and comprising a first part extending in the direction toward a side surface member; a second heat dissipating part plated on the rear surface of the rear case and comprising a second part extending in the direction toward the side surface member; a via hole passing through the first heat dissipating part and second heat dissipating part; and an edge heat dissipating part plated on one area of an edge connecting the front surface and rear surface of the rear case, and connecting the first heat dissipating part and second heat dissipating part into one body. Various other embodiments understood through the specification are also possible.

## Description

### [Technical Field]

Various embodiments of the disclosure relate to an electronic device including a heat dissipation member.

### [Background Art]

Recently, material cost reduction has been presented as a major issue along with intensifying competition among electronic device (e.g., smartphone) manufacturers. Accordingly, in order to effectively dissipate heat generated from electronic components mounted inside electronic devices, various technologies for internal structures of the electronic devices are being actively developed. For example, a heat dissipation member may be included inside an electronic device to dissipate heat generated from an electronic component to the outside.

### [Disclosure of Invention]

### [Technical Problem]

The heat dissipation member may be included in an electronic device in various forms. Among them, a graphite sheet configured to dissipate heat generated from an electronic component may be attached to a partial area of the rear case of the electronic device. The graphite sheet may be manually attached to the partial area of the rear case. In addition, when the graphite sheet is attached to a partial area of the rear case, since the graphite sheet is attached to a flat surface of the rear case to prevent it from being bent, the area to which the graphite sheet is attached may be limited.

Various embodiments of the disclosure are intended to provide an electronic device including a heat dissipation member in which a plating technology applied to an antenna (e.g., a laser manufacturing antenna (LMA)) is applied to a partial area of a rear case.

### [Solution to Problem]

An electronic device according to an embodiment disclosed herein may include a first plate facing a first direction, a second plate facing a second direction opposite to the first direction, a housing including an inner space defined by a side surface member perpendicular to the first plate and the second plate, a printed circuit board disposed in the inner space, an electronic component mounted on the printed circuit board, and a rear case coupled along the side surface member and including a heat dissipation member in a partial area thereof. The heat dissipation member may include a first heat dissipation portion plated on a front surface of the rear case corresponding to a top surface of the electronic component and including a first portion extending in a direction in which the side surface member is located, a second heat dissipation portion plated on a rear surface of the rear case and including a second portion extending in the direction in which the side surface member is located, a via hole penetrating the first heat dissipation portion and the second heat dissipation portion, and an edge heat dissipation portion plated in a partial area of a periphery interconnecting the front surface and the rear surface of the rear case to interconnect the first heat dissipation portion and the second heat dissipation portion as one body.

In addition, an electronic device according to an embodiment disclosed herein may include a first plate facing a first direction, a second plate facing a second direction opposite to the first direction, a housing including an inner space defined by a side surface member perpendicular to the first plate and the second plate, a printed circuit board disposed in the inner space, an electronic component mounted on the printed circuit board, and a rear case coupled along the side surface member and including a heat dissipation member plated in a partial area thereof. The heat dissipation member may include a first heat dissipation portion plated in a second area included in a first area corresponding to a top surface of the electronic component and including a first portion extending from the second area in a direction in which the side surface member is located, a second heat dissipation portion plated in a third area of the rear surface of the rear case and including a second portion extending from the third area in the direction in which the side surface member is located, a via hole penetrating the first heat dissipation portion and the second heat dissipation portion, an edge heat dissipation portion plated in a partial area of a periphery interconnecting the front surface and the rear surface of the rear case to interconnect the first heat dissipation portion and the second heat dissipation portion as one body, and a heat dissipation pattern provided on surfaces of the first heat dissipation portion and the second heat dissipation portion to dissipate thermal energy generated from the electronic component to a predetermined direction.

### [Advantageous Effects of Invention]

According to various embodiments disclosed herein, in an electronic device including a heat dissipation member, it is possible to save material and labor costs by replacing manual attachment of a graphite sheet to a partial area of a rear case with an LMA plating process.

In addition, according to various embodiments disclosed herein, LMA plating technology are applied to all areas requiring heat dissipation, instead of attaching graphite sheets only to flat surfaces, thereby enabling effective use of space.

Various other effects identified directly or indirectly through this document may be provided.

### [Brief Description of Drawings]

FIG. 1 is a front perspective view of an electronic device according to various embodiments of the disclosure.
FIG. 2 is a rear perspective view of the electronic device according to various embodiments of the disclosure.
FIG. 3 is an exploded perspective view illustrating each of a plurality of components of an electronic device according to various embodiments of the disclosure.
FIG. 4 is a view illustrating front and rear surfaces of a rear case including a heat dissipation member according to an embodiment.
FIG. 5 is a view illustrating sections obtained by partially cutting a heat dissipation member according to an embodiment.
FIG. 6 is a view illustrating a heat dissipation member including via holes according to an embodiment.
FIG. 7 is a view illustrating sections obtained by partially cutting heat dissipation members including via holes according to an embodiment.
FIG. 8 is a view illustrating areas in which heat dissipation members according to an embodiment are plated.
FIG. 9 is a view illustrating other areas in which heat dissipation members according to an embodiment are plated.
FIG. 10 is a view illustrating other areas in which heat dissipation members according to an embodiment are plated.
FIG. 11 is a view illustrating a heat dissipation pattern provided on a surface of a heat dissipation member according to an embodiment.
FIG. 12 is a block diagram of an electronic device according to various embodiments in a network environment.

### [Mode for Carrying out the Invention]

Hereinafter, various embodiments of the disclosure will be described with reference to the accompanying drawings. However, it is to be understood that this description is not intended to limit the disclosure to specific embodiments, and that various modifications, equivalents, and/or alternatives of embodiments of the disclosure are included. In connection with a description made with reference to the drawings, like reference numerals may be used for like elements.

An electronic device according to various embodiments of the disclosure may include at least one of, for example, a smartphone, a tablet personal computer (PC), a mobile phone, an image phone, an e-book reader, a desktop PC, a laptop PC, a netbook computer, a workstation, a server, a personal digital assistant (PDA), a portable multimedia player (PMP), an MP3 player, a mobile medical device, a camera, or a wearable device (e.g., smart eyeglasses, a head-mounted device (HMD), an electronic cloth, an electronic bracelet, an electronic necklace, an electronic accessory, an electronic tattoo, a smart mirror, or a smart watch).

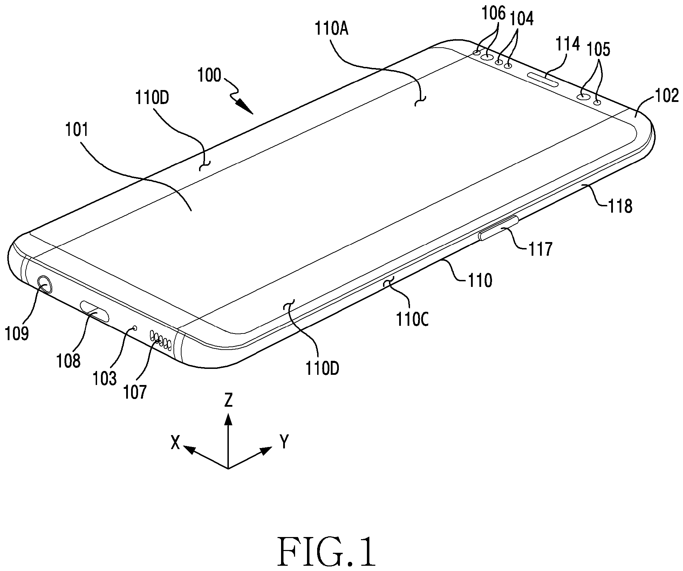

FIG. 1 is a front side perspective view illustrating an electronic device 100 according to various embodiments.

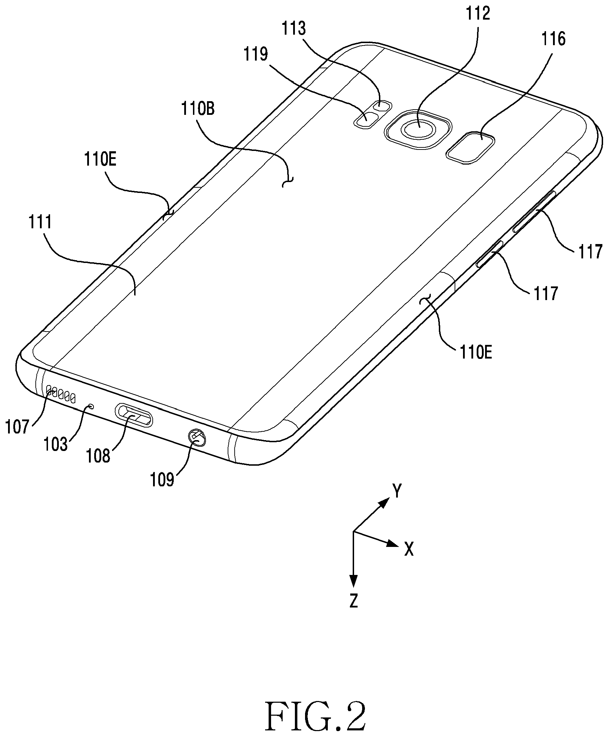

FIG. 2 is a rear side perspective view illustrating the electronic device 100 according to various embodiments.

Referring to FIGS. 1 and 2, the electronic device 100 according to an embodiment may include a housing 110 including a first face (or a front face) 110A, a second face (or a rear face) 110B, and a side face 110C surrounding the space between the first face 110A and the second face 110B. In another embodiment (not illustrated), the term "housing" may refer to a structure forming some of the first face 110A, the second face 110B, and the side face 110C of FIG. 1 According to an embodiment, at least a portion of the first face 110A may be formed of a substantially transparent front plate 102 (e.g., a glass plate or a polymer plate including various coating layers). The second face 110B may be formed by a substantially opaque rear plate 111. The rear plate 111 may be formed of, for example, coated or colored glass, ceramic, polymer, or metal (e.g., aluminum, stainless steel (STS), or magnesium), or a combination of two or more of these materials. The side face 110C may be formed by a side bezel structure 118 (or a "side member") coupled to the front plate 102 and the rear plate 111 and including a metal and/or a polymer. In some embodiments, the rear plate 111 and the side bezel structure 118 may be integrally formed, and may include the same material (e.g., a metal material such as aluminum).

In the illustrated embodiment, the front plate 102 may include, at the long opposite side edges thereof, two first areas 110D, which are bent from the first face 110A towards the rear plate 111 and extend seamlessly. In the illustrated embodiment (see FIG. 2), the rear plate 111 may include, at the long opposite side edges thereof, two second areas 110E, which are bent from the second face 110B towards the front plate 102 and extend seamlessly. In some embodiments, the front plate 102 (or the rear plate 111) may include only one of the first areas 110D (or the second areas 110E). In another embodiment, some of the first areas 110D and the second areas 110E may not be included. In the embodiments described above, when viewed from a side of the electronic device 100, the side bezel structure 118 may have a first thickness (or width) on the side faces, which do not include the first areas 110D or the second areas 110E, and may have a second thickness (or width), which is smaller than the first thickness, on the side faces, which include the first areas 110D or the second areas 110E.

According to an embodiment, the electronic device 100 may include at least one of a display 101, audio modules 103, 107, and 114, sensor modules 104, and 119, camera modules 105, 112, and 113, key input devices 117, light-emitting elements 106, and connector holes 108 and 109. In some embodiments, at least one of the components (e.g., the key input devices 117 or the light-emitting elements 106) may be omitted from the electronic device 100, or the electronic device 100 may additionally include other components.

According to an embodiment, the display 101 may be exposed through a large portion of, for example, the front plate 102. In some embodiments, at least a portion of the display 101 may be exposed through the front plate 102 forming the first face 110A and the first areas 110D of the side faces 110C. In some embodiments, the edges of the display 101 may be formed to be substantially the same as the shape of the periphery of the front plate 102 adjacent thereto. In another embodiment (not illustrated), the distance between the periphery of the display 101 and the periphery of the front plate 102 may be substantially constant in order to enlarge the exposed area of the display 101.

According to an embodiment, a surface (or the front surface plate 102) of the housing 110 may include a screen display area provided since the display 101 is visually exposed. For example, the screen display area may include a first surface 110A and first areas 110D of a side surface.

According to an embodiment (not illustrated), the display 101 includes audio modules 103, 107, and 114, sensor modules 104 and 119, and a camera module (e.g., the camera module may include at least one of a first camera module 105) and a light emitting device (not illustrated). For example, the electronic device 100 may include a camera module (e.g., the first camera module 105) disposed on the first surface (e.g., the front surface) 110A and/or the side surface 110C to face the first surface 110A and/or the side surface 110C. For example, the first camera module 105 may not be visually exposed to the screen display area and may include a hidden under-display camera (UDC). For example, the under-display camera may be disposed such that the optical axis of a lens passes through a pixel array included in the display 101.

According to one embodiment, the display 101 may be combined with or disposed adjacent to a touch sensing circuit, a pressure sensor capable of measuring the intensity (pressure) of a touch, and/or a digitizer that detects a magnetic field type stylus pen. In some embodiments, at least a portion of the sensor modules 104 and 119 and/or at least a portion of the key input device 117 may be disposed in the first regions 110D and/or the second regions 110E.

According to an embodiment, the audio modules 103, 107, and 114 may include a microphone hole 103 and speaker holes 107 and 114. The microphone hole 103 may include a microphone disposed therein so as to acquire external sound, and in some embodiments, multiple microphones may be disposed therein so as to detect the direction of sound. The speaker holes 107 and 114 may include an external speaker hole 107 and a phone call receiver hole 114. In some embodiments, the speaker holes 107 and 114 and the microphone hole 103 may be implemented as a single hole, or a speaker may be included without the speaker holes 107 and 114 (e.g., a piezo speaker).

According to an embodiment, the sensor modules 104, and 119 may generate an electrical signal or a data value corresponding to the internal operating state or the external environmental state of the electronic device 100. The sensor modules 104, and 119 may include, for example, a first sensor module 104 (e.g., a proximity sensor), a second sensor module (not illustrated) (e.g., a fingerprint sensor) disposed on the first face 110A of the housing 110. The fingerprint sensor may be disposed not only on the first face 110A of the housing 110 (e.g., the display 101), but also on the second face 110B. The electronic device 100 may further include at least one of sensor modules (not illustrated) such as a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor 104.

According to an embodiment, the camera modules 105, 112, and 113 may include, for example, a first camera device 105 disposed on the first face 110A of the electronic device 100 and a second camera device 112 and/or a flash 113 disposed on the second face 110B of the electronic device 100. The camera modules 105 and 112 may include one or more lenses, an image sensor, and/or an image signal processor. The flash 113 may include, for example, a light-emitting diode or a xenon lamp. In some embodiments, two or more lenses (e.g., an infrared camera lens, a wide-angle lens, and a telephoto lens) and image sensors may be disposed on one face of the electronic device 100.

According to one embodiment, the key input device 117 may include a side key button 117 disposed on a side face 110C of the housing 110. According to another embodiment, a touch pad 116 disposed around a home key button and a second camera 112 may be included as a key input device. Also, as a key input device, a home key button disposed on the first face 110A of the housing 110 may be included. In another embodiment, the electronic device 100 may not include some or all of the above-mentioned key input devices 117 and the key input device 117 that is not included may be implemented in other forms such as soft keys on the display 101.

According to an embodiment, the light-emitting element 106 may be disposed on, for example, the first face 110A of the housing 110. The light-emitting elements 106 may provide, for example, state information of the electronic device 100 in the form of light and may include an LED.

The connector holes 108 and 109 may include a first connector hole 108 that is capable of accommodating a connector (e.g., a USB connector) for transmitting and receiving power and/or data to and from an external electronic device, and/or a second connector hole 109 that is capable of receiving a connector (e.g., an earphone jack) for transmitting and receiving an audio signal to and from an electronic device.

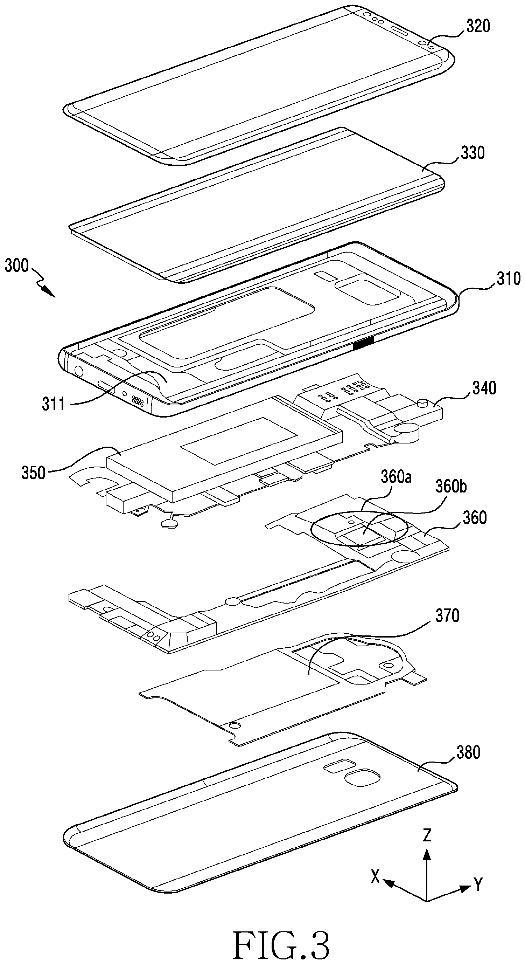

According to an embodiment, the electronic device 100 has a bar-type or plate-type exterior, but the disclosure is not limited thereto. For example, the illustrated electronic device 100 may be a portion of a foldable electronic device, a slidable electronic device, a stretchable electronic device, and/or a rollable electronic device. The term "foldable electronic device", the "slidable electronic device", the "stretchable electronic device", and/or the "rollable electronic device" may mean an electronic device in which bending deformation of a display (e.g., the display 330 in FIG. 3) is possible such that the display may be at least partially folded, wound or rolled, at least partially expanded in area, and/or accommodated inside a housing (e.g., the housing 110 in FIGS. 1 and 2). In the case of the foldable electronic device, the slidable electronic device, the stretchable electronic device, and/or the rollable electronic device, a user may use a screen display area in an expanded state by unfolding the display or exposing a greater area of the display to the outside if necessary.

FIG. 3 is an exploded perspective view illustrating an electronic device 300 according to various embodiments.

Referring to FIG. 3, the electronic device 300 includes a side bezel structure 310, a first support member 311 (e.g., a bracket), a front plate 320, a display 330, and a printed circuit board 340. (e.g., a printed circuit board (PCB), a printed board assembly (PBA), a flexible PCB (FPCB), or a rigid-flexible PCB (RFPCB)), a battery 350, a second support member 360 (e.g., a rear case (rear case)), an antenna 370, and a rear plate 380. In some embodiments, the electronic device 300 may omit at least one of the components (e.g., the first support member 311 or the second support member 360) or may additionally include other components. For example, the front surface of the second support member 360 is a first region 360a corresponding to the upper surface (e.g., a surface facing the -Z axis) of an electronic component (e.g., processor) mounted on the printed circuit board 340. (e.g., an area formed upward in the Y-axis direction) may be included. The first area 360a may include the second area 360b. The first area 360a may be, for example, an area located above the second support member 360 (e.g., above the Y-axis direction). At least one of the components of the electronic device 300 may be the same as or similar to at least one of the components of the electronic device 100 of FIG. 1 or 2, and duplicate descriptions are omitted below.

According to an embodiment, the first support member 311 may be disposed inside the electronic device 300 and connected to the side bezel structure 310 or integrally formed with the side bezel structure 310. The first support member 311 may be formed of, for example, a metal material and/or a non-metal (e.g., polymer) material. The display 330 may be coupled to one surface of the first support member 311 and the printed circuit board 340 may be coupled to the other surface. A processor, memory, and/or interface may be mounted on the printed circuit board 340. The processor may include, for example, one or more of a central processing unit, an application processor, a graphics processing unit, an image signal processor, a sensor hub processor, or a communication processor.

According to an embodiment, the memory may include, for example, volatile memory or nonvolatile memory.

According to an embodiment, the interface may include, for example, a high-definition multimedia interface (HDMI), a universal serial bus (USB) interface, an SD card interface, and/or an audio interface. The interface may electrically or physically connect, for example, the electronic device 300 to an external electronic device, and may include a USB connector, an SD card/an MMC connector, or an audio connector.

According to an embodiment, the battery 350 is a device for supplying power to at least one component of the electronic device 300, and may include, for example, a non-rechargeable primary battery, a rechargeable secondary battery, or a fuel cell. At least a portion of the battery 350 may be disposed on substantially the same plane as, for example, the printed circuit board 340. The battery 350 may be integrally disposed within the electronic device 300, or may be detachably mounted on the electronic device 300.

According to an embodiment, the antenna 370 may be disposed between the rear plate 380 and the battery 350. The antenna 370 may include, for example, a nearfield communication (NFC) antenna, a wireless charging antenna, and/or a magnetic secure transmission (MST) antenna. The antenna 370 may perform short-range communication with, for example, an external electronic device, or may transmit/receive power required for charging to/from the external device in a wireless manner. In another embodiment, an antenna structure may be formed by the side bezel structure 310, a portion of the first support member 311, or a combination thereof.

Hereinafter, exemplary structures of electronic devices to which various embodiments of the disclosure are applicable may be described with reference to FIGS. 1 to 3. However, FIGS. 1 to 3 only illustrate structures of an electronic device by way of example, and the structures of an electronic device are not limited to those illustrated in FIGS. 1 to 3. For example, an electronic device may have a structure in which a housing divided into multiple areas is folded by including one or more hinge structures.

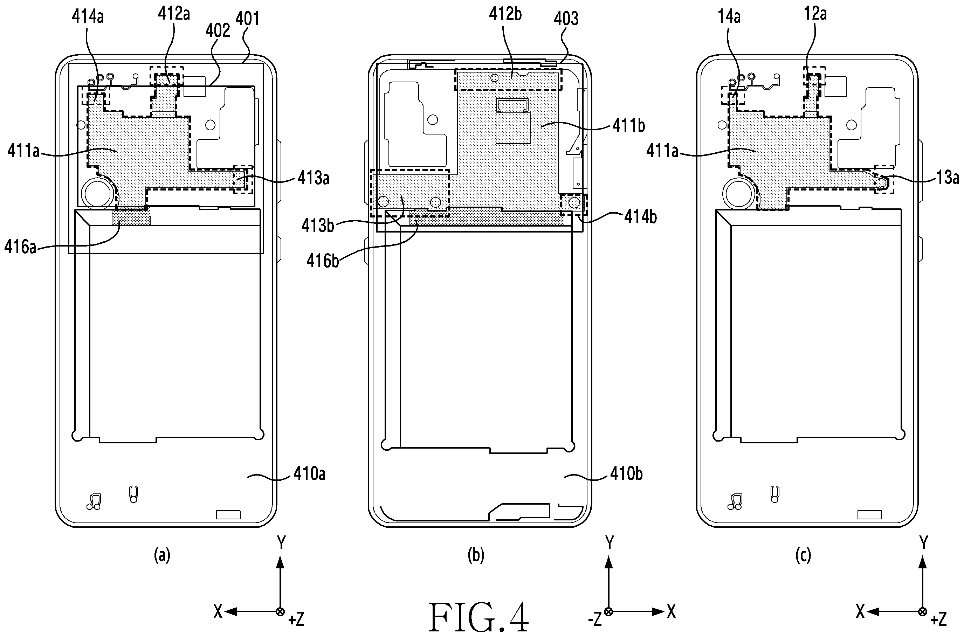

FIG. 4 illustrates plan views each illustrating a state in which heat dissipation members are disposed in an electronic device according to an embodiment.

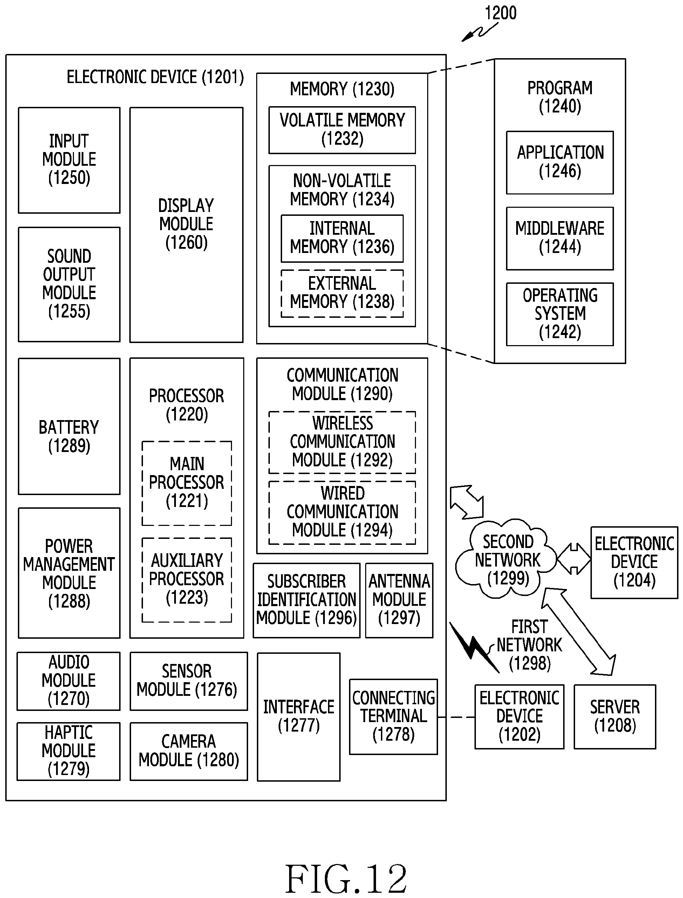

Image (a) of FIG. 4 may be a view illustrating the front surface 410a of a rear case (e.g., the second support member 360 in FIG. 3). Image (b) of FIG. 4 may be a view illustrating the rear surface 410b of the rear case. Image (c) of FIG. 4 may be a view illustrating the front surface of a rear case in which a graphite sheet of the prior art is attached for comparison with the front surface 410a of the rear case of image (a) of FIG. 4. Referring to FIG. 4, an electronic device (e.g., the electronic device 100 of FIG. 1 or the electronic device 1201 of FIG. 12) according to various embodiments may include a heat dissipation member (e.g., the first heat dissipation portion 411a and the second heat dissipation portion 411b) configured to dissipate thermal energy generated from an electronic component mounted in the electronic device to the outside. For example, the electronic component may be a processor. The processor may generate thermal energy when executing one or more operations.

According to an embodiment, the electronic device may include a first plate (e.g., the front surface plate 102 in FIG. 1), a second plate (e.g., the rear surface plate 111 in FIG. 2), and a housing (e.g., the housing 110 in FIG. 1) including an inner space defined by a side surface member (e.g., the side surface member 118 of FIG. 1) substantially perpendicular to the first plate and the second plate. The housing may include the heat dissipation member (e.g., the first heat dissipation portion 411a and the second heat dissipation portion 411b).

According to an embodiment, image (a) of FIG. 4 may be a view illustrating the front surface 410a (e.g., the surface facing the Z-axis direction) of the rear case (e.g., the second support member 360 in FIG. 3) disposed adjacent to a printed circuit board (e.g., the printed circuit board 340 of FIG. 3) included in the housing. The front surface 410a of the rear case may include a first area 401 (e.g., the first area 360a of the second support member 360 in FIG. 3 disposed at the upper side in the Y-axis direction) corresponding to the top surface (e.g., the surface facing the -Z-axis direction) of the electronic component mounted on the printed circuit board. The first area 401 may include a second area 402. For example, the first area 401 may be an area located at the upper side (e.g., the upper side in the Y-axis direction) of the rear case.

According to an embodiment, the rear case may include a heat dissipation member (e.g., the first heat dissipation portion 411a and the second heat dissipation portion 411b) in at least one partial area thereof. The heat dissipation member (e.g., the first heat dissipation portion 411a and the second heat dissipation portion 411b) may be provided by being plated in at least a portion of the rear case.

According to an embodiment, the first heat dissipation member may include a first heat dissipation portion 411a disposed in the second area 402 included in the first area 401 of the front surface 410a of the rear case. The first heat dissipation portion 411a may be plated in at least a portion of the second area 402 and may be a heat dissipation structure configured to dissipate heat energy generated from the electronic component. For example, the first heat dissipation portion 411a of the heat dissipation member may correspond to the top surface (e.g., the surface facing the -Z-axis direction) of the electronic component.

According to an embodiment, the first heat dissipation portion 411a may include first portions 412a, 413a, and 414a. The first portions 412a, 413a, and 414a may be plated in the second area 402 up to the periphery of the electronic device in which the side surface member is located or to the vicinity of the periphery. For example, the first portions 412a, 413a, and 414a of the first heat dissipation portion 411a may have shapes extending to be close to the electronic component or another module. In the first heat dissipation portion 411a, the first portions 412a, 413a, and 414a may extend such that the first heat dissipation portion 411a efficiently dissipates heat energy generated from the electronic component. In addition, the first portions 412a, 413a, and 414a may be disposed close to other modules mounted inside the housing as well as electronic components mounted on the printed circuit board. For example, the first portions 412a, 413a, and 414a may be the extending portions of the first heat dissipation portion 411a that are plated to the vicinity of an area in which a camera module and a communication module mounted inside the housing are disposed.

According to an embodiment, image (b) of FIG. 4 may be a view illustrating the rear surface 410b of the rear case in the state in which the second plate of the electronic device is removed. The rear surface 410b of the rear case may include a third area 403 facing a second direction (e.g., the Z-axis direction) opposite to the first direction (e.g., the -Z-axis direction), which is the front direction of the electronic device. The third area 403 may be located on the opposite side of the second area 402 with respect to the Z axis.

According to an embodiment, the rear surface 410b (e.g., the surface facing the Z-axis direction) of the rear case may include a second heat dissipation portion 411b plated in at least a portion of the third area 403. For example, the second heat dissipation portion 411b may be plated over an area greater than that of the first heat dissipation portion 411a.

According to an embodiment, the second heat dissipation portion 411b may include second portions 412b, 413b, and 414b. The second portions 412b, 413b, and 414b may be the extending portions of the second heat dissipation portion 411b that are plated in the third area 403 up to the periphery of the electronic device in which the side surface member is located or to the vicinity of the periphery. For example, in the second heat dissipation portions 411b, the second portions 412b, 413b, and 414b may extend to efficiently dissipate thermal energy generated from the electronic component. For example, the second portions 412b, 413b, and 414b may have shapes extending to be close to an electronic component or another module. In addition, the second portions 412b, 413b, and 414b may be disposed close to other modules mounted inside the housing as well as electronic components mounted on the printed circuit board. For example, the second portions 412b, 413b, and 414b may be the extending portions of the second heat dissipation portion 411b that are plated to the vicinity of an area in which a camera module and a communication module mounted inside the housing are disposed.

Comparing image (a) and image (c) of FIG. 4, the first portions 412a, 413a, and 414a of the first heat dissipation portion 411a have an area greater than that of the first portions 12a, 13a, and 14a of a graphite sheet of the prior art. The first portions 412a, 413a, and 414a of the first heat dissipation portion 411a may improve heat dissipation performance by having a large area.

According to an embodiment, the second heat dissipation portion 411b may dissipate heat energy absorbed by the first heat dissipation portion 411a from the electronic component or the module to an external low-temperature area. The second heat dissipation portion 411b may dissipate heat energy received from the first heat dissipation portion 411a through the second portions 412b, 413b, and 414b.

According to an embodiment, the heat dissipation member may further include edge heat dissipation portions 416a and 416b. Of the edge heat dissipation portions 416a and 416b, a first edge heat dissipation portion 416a may be provided by plating a portion of an edge of the first heat dissipation portion 411a, and a second edge heat dissipation portion 416b may be provided by plating a portion of the second heat dissipation portion 411b. The inner side and the outer side of the rear case may be connected by the first edge heat dissipation portion 416a and the second edge heat dissipation portion 416b. The rear case may be used as a heat dissipation plate by providing the edge heat dissipation portions 416a and 416b by plating an inner portion and an outer portion of the rear case. The area of the heat dissipation area may be increased (e.g., doubled) by providing the edge heat dissipation portions 416a and 416b by plating an edge portion interconnecting the inner and outer surfaces of the rear case.

The edge heat dissipation portions 416a and 416b may interconnect the first heat dissipation portion 411a and the second heat dissipation portion 411b as one body. The edge heat dissipation portions 416a and 416b are provided by interconnecting a partial area of the periphery of the first heat dissipation portion 411a and a partial area of the periphery of the second heat dissipation portion 411b inside the rear case. For example, the edge heat dissipation portions 416a and 416b, which interconnect the first heat dissipation portion 411a and the second heat dissipation portion 411b as one body, may dissipate heat energy generated from the electronic component in a horizontal direction (e.g., a direction parallel to the XY-axis plane) of the electronic device.

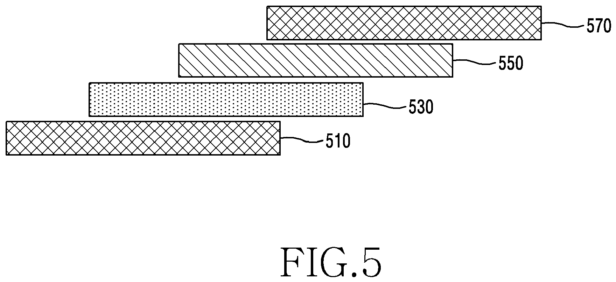

FIG. 5 is a view illustrating sections obtained by partially cutting a heat dissipation member according to an embodiment.

Referring to FIGS. 1 and 5, according to an embodiment, an electronic device (e.g., the electronic device 100 in FIG. 1) may include a first plate (e.g., the front surface plate 102 in FIG. 1), a second plate (e.g., the rear surface plate 111 in FIG. 2), and a housing (e.g., the housing 110 in FIG. 1) including an inner space defined by a side surface member (e.g., the side surface member 118 of FIG. 1) substantially perpendicular to the first plate and the second plate.

According to an embodiment, the housing may include a rear case (e.g., the second support member 360 in FIG. 3). The rear case may include heat dissipation members (e.g., the first heat dissipation portion 411a or the second heat dissipation portion 411b of FIG. 4), which have different areas, in at least partial areas of the front and rear surfaces, respectively.

According to an embodiment, the heat dissipation members may be provided in at least one partial area of the rear case through laser manufacturing antenna (LMA) plating. For example, the heat dissipation members may be plated in at least one partial area of the rear case.

According to an embodiment, the heat dissipation members may be configured in a multi-layer (e.g., four layer) laminated structure and may have a thickness of about 7 µm to 12 µm. However, the heat dissipation members are not limited to the above-mentioned the thickness and may have a thickness that is variable depending on the adding or removing and laminating order of other materials.

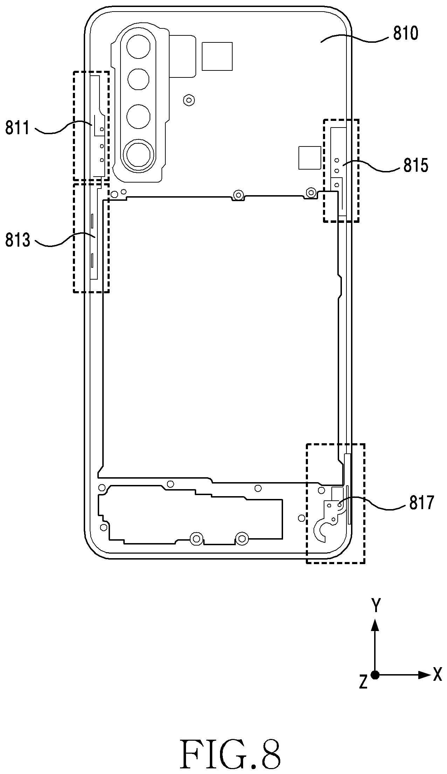

According to an embodiment, in order to plate the heat dissipation members on the rear case, a hatched area may be created by emitting a laser beam to a surface of the rear case. The hatched area may have a lower step than other areas of the rear case to which no laser beam is emitted. An ultraviolet ray (UV) laser or a fiber laser may be used as a laser to create the hatched area on the surface of the rear case, but is not limited thereto. In an embodiment, a laser source for creating the hatched area may be configured differently depending on a disposed position, size, and/or performance of the heat dissipation members. For example, the laser beam may be emitted to the surface of the rear case while varying the power, speed, hatching pitch, hatching angle, and/or the number of times of hatching of the laser source. Referring to FIGS. 8 to 10, the heat dissipation members may be disposed in various areas of the electronic device 100, and the laser beams may be configured to be differently emitted to respective areas (e.g., the first to fourth areas 811, 813, 815, and 817 in FIG. 8) (e.g., configuration of laser beams).

According to an embodiment, a first section 510 may be laminated on the top surface of the hatched area. The first section 510 may be made of a material that is preferentially adsorbed to the top surface of the hatched area to configure the heat dissipation member. For example, the first section 510 may be made of nickel (Ni) and may have a thickness of about 1 µm to about 2 µm. A second section 530 may be laminated on the top surface of the first section 510 adsorbed to the hatched area. The second section 530 may be made of a material different from that of the first section 510. For example, the second section 530 may be made of silver (Ag) and may have a thickness of about 1 µm to about 2 µm.

According to an embodiment, a third section 550 may be laminated on the top surface of the second section 530. The third section 530 may be made of a material different from those of the first section 510 and the second section 530 and may have a thickness greater than those of the first section 510 and the second section 530. For example, the third section 530 may be made of copper (Cu) and may have a thickness of about 3 µm to about 5 µm.

According to an embodiment, a fourth section 570 may be laminated on the upper surface of the third section 550. The fourth section 570 may be made of the same material as the first section 510. For example, the fourth section 570 may be made of nickel (Ni) and may have a thickness of about 2 µm to about 3 µm. For example, the heat dissipation member may be provided by being plated in at least one partial area of the rear case in a structure in which nickel (about 1 to 2 µm), silver (about 1 to 2 µm), copper (about 3 to 5 µm), and nickel (about 2 to 3 µm) are laminated from the surface of the rear case.

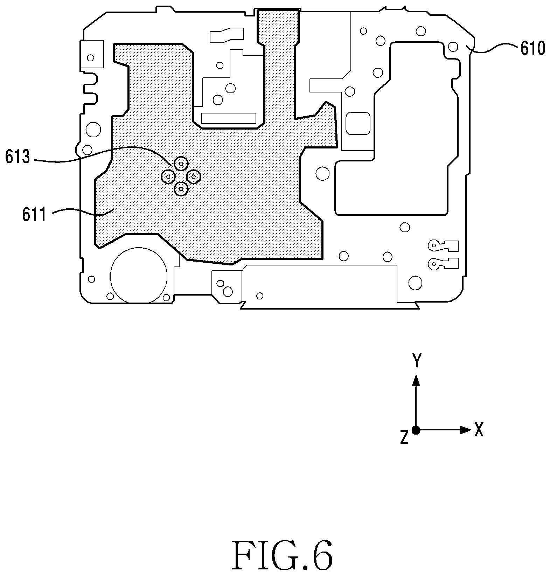

FIG. 6 is a view illustrating a heat dissipation member including via holes according to an embodiment.

Referring to FIG. 6, an electronic device may include a first plate (e.g., the front surface plate 102 in FIG. 1), a second plate (e.g., the rear surface plate 111 in FIG. 2), and a housing (e.g., the housing 110 in FIG. 1) including an inner space defined by a side surface member (e.g., the side surface member 118 of FIG. 1) substantially perpendicular to the first plate and the second plate. The housing may include a heat dissipation member 611.

According to an embodiment, the heat dissipation member 611 may be included in a state of being plated in at least one partial area of a rear case 610 (e.g., the second support member 360 in FIG. 3) located inside the housing. The heat dissipation member 611 may be located in at least one partial area of each of the front and rear surfaces of the rear case 610. The heat dissipation member 611 located on the rear surface of the rear case 610 may have an area greater than that of the heat dissipation member 611 located on the front surface of the rear case 610.

According to an embodiment, the heat dissipation members 611 may include a first heat dissipation portion (e.g., the first heat dissipation portion 411a in FIG. 4) located on the front surface of the rear case and a second heat dissipation portion (e.g., the second heat dissipation portion 411b in FIG. 4) located on the rear surface of the rear case.

According to an embodiment, the heat dissipation members 611 may include a via hole 613 penetrating the first heat dissipation portion and the second heat dissipation portion. One or more via holes 613 may be included in at least one partial area of the heat dissipation member 611. For example, the via holes 613 may be provided in a first portion (e.g., the first portions 412a, 413a, and 414a in FIG. 4) and a second portion (e.g., the second portions 412b, 413b, and 414b in FIG. 4) of the heat dissipation member.

According to an embodiment, the via holes 613 may be located in an area of the heat dissipation members corresponding to a printed circuit board included in the housing. More specifically, the via holes 613 may be located in an area of the heat dissipation member corresponding to one surface (e.g., the top surface) of an electronic component mounted on the printed circuit board.

According to an embodiment, the heat dissipation members may transfer thermal energy generated from an electronic component to the via holes 613 located in the second heat dissipation portion through the via holes 613 located in the first heat dissipation portion. The heat dissipation members may dissipate thermal energy transferred to the via hole 613 located in the second heat dissipation portion, through the second dissipation portion located on the rear surface.

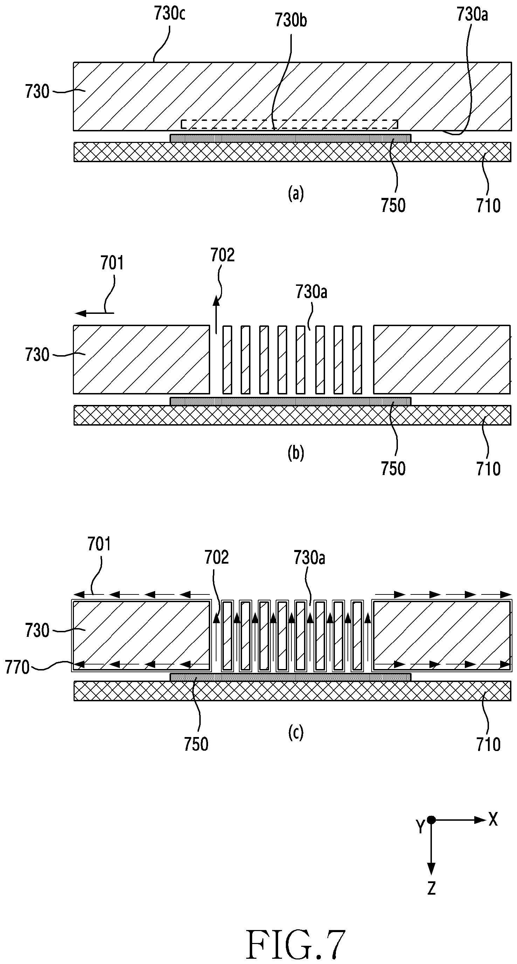

FIG. 7 is a view illustrating sections obtained by partially cutting heat dissipation members including via holes according to an embodiment.

Referring to image (a) of FIG. 7, an electronic device may include a first plate (e.g., the front surface plate 102 in FIG. 1), a second plate (e.g., the rear surface plate 111 in FIG. 2), and a housing (e.g., the housing 110 in FIG. 1) including an inner space defined by a side surface member (e.g., the side surface member 118 of FIG. 1) substantially perpendicular to the first plate and the second plate. The housing may include a rear case 730 (e.g., the second support member 360 in FIG. 3).

According to an embodiment, the rear case 730 may include a second area 730b. The second area 730b may be an area that is included in a first area (e.g., the first area 360a in FIG. 3) of the rear case 730 that corresponds to the top surface (e.g., the surface facing the -Z axis direction) of the printed circuit board 710. For example, the second area 730b may be located on the front surface (e.g., the surface facing the Z-axis direction) of the rear case 730 corresponding to the printed circuit board 710, and due to the correspondence with the printed circuit board 710, the second area 730b may correspond to one surface (e.g., the surface facing the -Z axis direction) of an electronic component (e.g., a processor) mounted on the printed circuit board 710.

According to an embodiment, the rear case 730 may include a third area 730c. The third area 730c may face a direction (e.g., the -Z-axis direction) opposite to the direction (e.g., the Z-axis direction) the second area 730b faces. For example, the third area 730c may be an area located on the rear surface (e.g., the surface facing the -Z axis direction) of the rear case 730.

According to an embodiment, when the electronic device executes a specific operation, thermal energy may be generated from an electronic component mounted on the printed circuit board 710. When thermal energy is generated from the electronic component, a hot spot area 750 may occur. The hot spot area may be an area that has a higher temperature than other areas within the housing and may occur as thermal energy is continuously generated from the electronic component.

Referring to image (b) of FIG. 7, the rear case 730 may include multiple via holes 730a (e.g., the via holes 613 in FIG. 6). The via holes 730a may be one or more holes that penetrate the rear case in a direction 702 (e.g., the Z-axis direction) substantially perpendicular to a horizontal direction 701 (e.g., a direction parallel to the XY plane) of the second area 730b and the third area 730c.

According to an embodiment, the via holes 730a may be located in an area of the rear case 730 corresponding to the hot spot area 750. The via holes 730a may transfer the thermal energy of the hot spot area 750 from the second area to the third area 730c. The via holes 730a may be holes for effectively dissipating heat energy within the housing to the outside.

Referring to (c) of FIG. 7, a heat dissipation member 770 may be plated on the surface of the rear case 730.

According to an embodiment, the heat dissipation member 770 may be plated on the surface of the second area 730b and/or the surface of the third area 730c. The heat dissipation member 770 may be plated in at least one partial area of the rear case 730. The heat dissipation member 770 may be laminated to have a multi-layer (e.g., four-layer) structure. The heat dissipation member 770 may be plated on the surface of the rear case 730 through laser manufacturing antenna (LMA) plating.

According to an embodiment, the heat dissipation member 770 plated in the second area may dissipate the heat energy in the horizontal direction 701 (e.g., the direction parallel to the XY plane) of the electronic device. In addition, the heat dissipation member 770 may be plated on the inner surfaces of the via holes 730a. The heat dissipation member 770 plated on the inner surfaces of the via holes 730a may transfer thermal energy from the hot spot area 750 to the third area 730c in a short time. The heat dissipation member 770 plated on the third area 730c may dissipate the transferred thermal energy in the horizontal direction of the electronic device. For example, the heat dissipation member 770 may dissipate a large amount of heat energy to a low temperature area within a short period of time.

FIG. 8 is a view illustrating areas in which heat dissipation members according to an embodiment are plated.

According to an embodiment, an electronic device (e.g., the electronic device 100 in FIG. 1) may include a first plate (e.g., the front surface plate 102 in FIG. 1), a second plate (e.g., the rear surface plate 111 in FIG. 2), and a housing (e.g., the housing 110 in FIG. 1) including an inner space defined by a side surface member (e.g., the side surface member 118 of FIG. 1) substantially perpendicular to the first plate and the second plate.

Referring to FIG. 8, the electronic device may include at least one antenna module (e.g., the antenna module 1297 of FIG. 12) in the housing. For example, the antenna module may be mounted on a printed circuit board. The antenna module may include at least one antenna array supporting mm Wave frequency band communication.

According to an embodiment, the antenna module may be disposed adjacent to the side surface member (e.g., the side surface member 118 in FIG. 1) and may have a gap with respect to the inner surface of the side surface member. One or more antenna modules may be arranged in this manner. The one or more antenna modules mounted on the printed circuit board (e.g., the printed circuit board 340 of FIG. 3) may generate thermal energy during operation. The thermal energy generated from the one or more antenna modules may be locally generated.

According to an embodiment, the rear case 810 may include a first area 811, a second area 813, and a third area 815. The first area 811, the second area 813, and the third area 815 may include areas in which the one or more antenna modules are mounted. The rear case 810 may include heat dissipation members adj acent to the first area 811, the second area 813, and the third area 815. The heat dissipation members may dissipate thermal energy locally generated from the antenna modules included in the first area 811, the second area 813, and the third area 815.

According to another embodiment, the antenna modules may include the heat dissipation members (e.g., the first heat dissipation portions 411a of FIG. 4) and second heat dissipation portions (e.g., the second heat dissipation portions 411b of FIG. 4). The heat dissipation members may be structures provided through laser manufacturing antenna (LMA) plating on the surfaces of the antenna modules. For example, the heat dissipation members plated on the antenna modules may dissipate thermal energy generated from the antenna modules.

According to an embodiment, the heat dissipation members may be plated in at least one partial area of the periphery of the rear case 810 and may extend to a fourth area 817 below the side surface member.

According to an embodiment, the heat dissipation members may include a first heat dissipation portion (e.g., the first heat dissipation portions 411a in FIG. 4) and a second heat dissipation portion (e.g., the second heat dissipation portions 411b in FIG. 4). The first heat dissipation portion 411a may be located in a second area of the rear case 810. The second area may correspond to the top surface of the printed circuit board and may be located on the front surface of the rear case 810. The first heat dissipation portion 411a may transfer thermal energy of the hot spot area to the second heat dissipation portion in a third area. The third area may be an area located on the rear surface of the rear case 810.

Although not illustrated in FIG. 8, the second heat dissipation portion 411b may include a second portion (e.g., the second portions 412b, 413b, and 414b in FIG. 4) extending to the vicinity of the side surface member. The second portion may extend from the second heat dissipation portion 411b to the vicinities of the first area 811, the second area 813, and the third area 815, and may absorb thermal energy generated from the one or more antenna modules and may dissipate the thermal energy to the fourth area 817.

According to an embodiment, the first to fourth areas 811, 813, 815, and 817 may generate different types of hatched areas in the rear case 810 and/or the antenna modules. For example, a first type of emission is performed in the first area 811 related to a low-frequency band to form a first pattern, and a second type of emission may be performed in the second area 813 related to a high-frequency band to form a second pattern having a greater depth and area than those of the first pattern. According to an embodiment, through LMA plating, the thickness of the heat dissipation member provided in the second area 813 may be greater than that of the heat dissipation member provided in the first area 811. For example, the first type may include a type in which laser beams are emitted at a speed of 2000 mm/sec and a hatching pitch of 0.08 mm with an output corresponding to 60% of the maximum output of the laser source while the laser beams are emitted twice at one or more hatching angles selected from among 45 degrees, 135 degrees, 0 degrees, and 90 degrees, and the second type may include a type in which laser beams are emitted at a speed of 1800 mm/sec and a hatching pitch of 0.1 mm with an output corresponding to 70% of the maximum output of the laser source while the laser beams are emitted three or fourth times at one or more hatching angles selected from among 45 degrees, 135 degrees, 0 degrees, and 90 degrees.

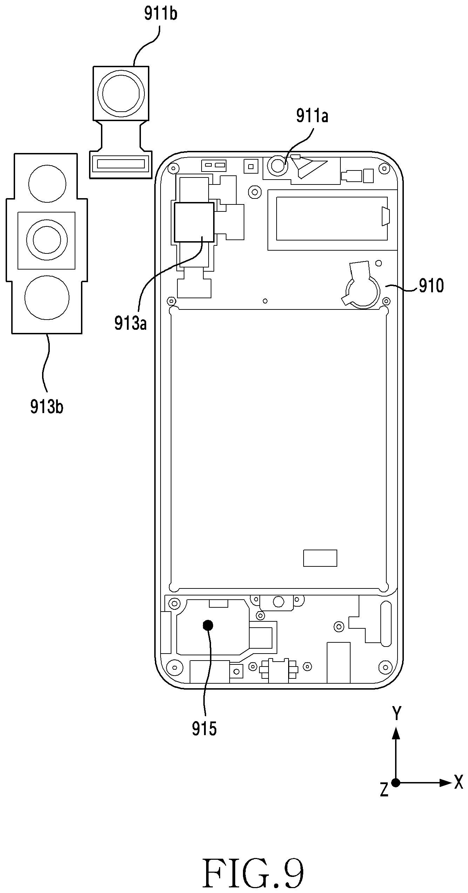

FIG. 9 is a view illustrating other areas in which heat dissipation members according to an embodiment are plated.

Referring to FIG. 9, an electronic device (e.g., the electronic device 100 in FIG. 1) may include a first plate (e.g., the front surface plate 102 in FIG. 1), a second plate (e.g., the rear surface plate 111 in FIG. 2), and a housing (e.g., the housing 110 in FIG. 1) including an inner space defined by a side surface member (e.g., the side surface member 118 of FIG. 1) substantially perpendicular to the first plate and the second plate.

According to an embodiment, the electronic device may further include a bracket 910 (e.g., the first support member 311 of FIG. 1). The bracket 910 may be disposed to be stacked at a position close to a printed circuit board (e.g., the printed circuit board 340 in FIG. 3) disposed in the housing. For example, the bracket 910 may be located on the top surface of the printed circuit board.

According to an embodiment, the bracket 910 may include a first camera area 911a and a second camera area 913a. The first camera area 911a may be an area in which a first camera module 911b (e.g., a front camera) is disposed. The second camera area 913a may be an area in which a second camera module 913b (e.g., a rear camera) is disposed.

According to one embodiment, the bracket 910 may further include a speaker housing 915. The speaker housing 915 may be disposed in a lower partial area of the bracket 910 and may include a speaker module.

According to an embodiment, the bracket 910 may include a heat dissipation member in the first camera area 911a and/or the second camera area 913a. The heat dissipation member may be a structure provided through laser manufacturing antenna (LMA) plating. The first heat dissipation member plated in the first camera area 911a may dissipate thermal energy generated when the first camera module 911b operates in a low-temperature area. The second heat dissipation member plated in the second camera area 913a may dissipate thermal energy generated when the second camera module 913b operates in a low-temperature area. For example, the heat dissipation members of the first camera area 911a and/or the second camera area 913a, which are visually exposed to the outside and obtain a light source from the outside, may be disposed in at least portions of the surfaces on which the first camera module 911b and/or the second camera module 913b are mounted (seated). For example, the heat dissipation members may be disposed on a surface that surrounds the first camera area 911a and/or the second camera area 913a and is least partially in contact with the first camera module 911b and/or the second camera module 913b.

According to an embodiment, the bracket 910 may include a heat dissipation member near an area in which the speaker housing 915 is located. The heat dissipation member near the area in which the speaker housing 915 is located may dissipate heat energy generated when the speaker module operates in a low-temperature area. According to an embodiment, the heat dissipation member may be provided on at least a portion of the speaker housing 915. For example, the speaker housing 915 (e.g., enclosure) may refer to a housing or casing surrounding a speaker module, and may be a resonator that generates a large volume by collecting at least some of the sound generated from the speaker module. According to an embodiment, the heat dissipation member may be provided on one surface (e.g., the surface facing the Z-axis direction) of the speaker housing 915 through plating (e.g., LMA plating) instead of using a designated sheet (e.g., graphite sheet).

According to another embodiment, the electronic device may further include a rear case (e.g., the second support member 360 in FIG. 3) disposed on the upper surface (e.g., the surface facing the -Z axis direction) of the bracket 910. The rear case 360 disposed on the top surface of the bracket 910 may include the first camera area 911a and/or the second camera area 913a.

According to another embodiment, the rear case 360 may include an opening into which at least a portion of the second camera module 913b is inserted. The rear case 360 may include a heat dissipation member near the opening. The heat dissipation member plated near the opening may dissipate thermal energy generated when the second camera module 913b operates. In addition, the heat dissipation member near the opening may be connected to a heat dissipation member plated in another area of the rear case 360 to increase a heat dissipation area for dissipating thermal energy. For example, the heat dissipation member may be plated not only on the rear case 360 but also on the bracket 910, but is not limited thereto when there are configurations and areas requiring dissipation of thermal energy.

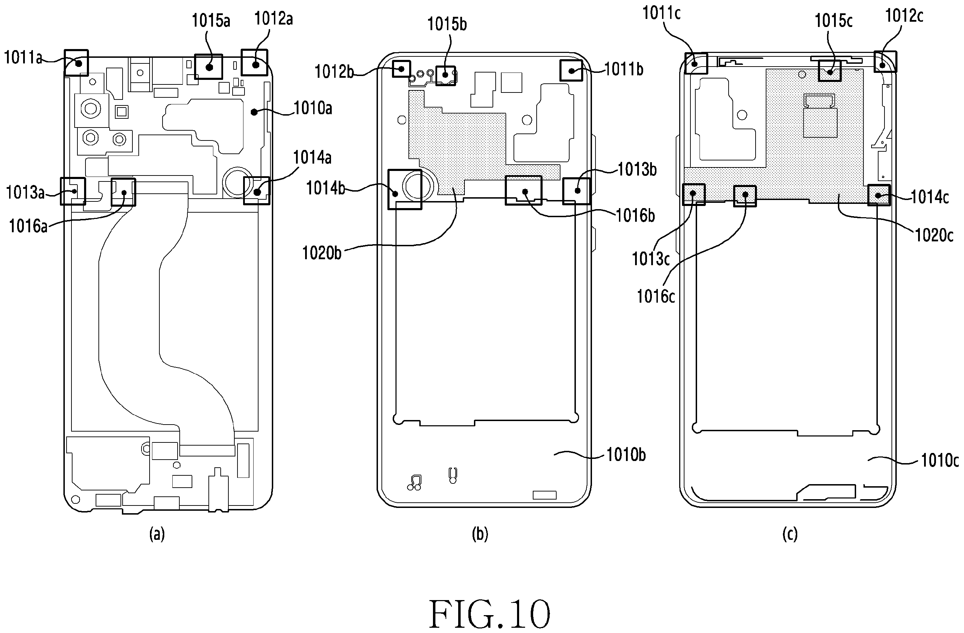

FIG. 10 is a view illustrating other areas in which heat dissipation members according to an embodiment are plated.

According to an embodiment, an electronic device (e.g., the electronic device 100 in FIG. 1) may include a first plate (e.g., the front surface plate 102 in FIG. 1), a second plate (e.g., the rear surface plate 111 in FIG. 2), and a housing (e.g., the housing 110 in FIG. 1) including an inner space defined by a side surface member (e.g., the side surface member 118 of FIG. 1) substantially perpendicular to the first plate and the second plate.

Referring to image (a) of FIG. 10, the housing may include a bracket (e.g., the first support member 311 in FIG. 3) and a printed circuit board 1010a (e.g., the printed circuit board 340 in FIG. 3). For example, the printed circuit board 1010a may be disposed to be stacked on the top surface of the bracket.

According to an embodiment, at least one electronic component may be mounted on the printed circuit board 1010a. For example, the electronic component may be a processor. Corners of the printed circuit board 1010a may be cut and removed. The printed circuit board 1010a may be disposed to be stacked on the top surface of the bracket in the state in which the corners are removed. However, without being limited thereto, the stacking order of the bracket and the printed circuit board 1010a may be changed.

According to an embodiment, the printed circuit board 1010a may include first coupling holes 1015a and 1016a in some areas. The first coupling holes 1015a and 1016a are coupling holes located inside the printed circuit board 1010a and may be spaces into which first screws corresponding to the standard of the first coupling holes 1015a and 1016a are inserted. The first screws may be made of a thermal conductor.

According to an embodiment, the bracket may include second coupling holes 1011a, 1012a, 1013a, and 1014a. The second coupling holes 1011a, 1012a, 1013a, and 1014a may be spaces into which second screws corresponding to the standard of the second coupling holes 1011a, 1012a, 1013a, and 1014a are inserted. The second screws may be made of a thermal conductor.

Referring to image (b) of FIG. 10, the electronic device may include a rear case (e.g., the second support member 360 in FIG. 3) within the housing.

According to an embodiment, the rear case may be disposed to be stacked on the top surface of the printed circuit board 1010a. Image (b) of FIG. 10 may be a view illustrating the front surface 1010b of the rear case. The front surface 1010b of the rear case may include a first heat dissipation portion 1020b (e.g., the first heat dissipation portion 411a in FIG. 4). The first heat dissipation portion 1020b may be included in a heat dissipation member and may be a heat-dissipation structure plated in at least one partial area of the front surface 1010b of the rear case. The heat dissipation member may be provided on a surface of the rear case through laser manufacturing antenna (LMA) plating.

According to an embodiment, the front surface 1010b of the rear case may include third coupling holes 1015b and 1016b. In addition, the front surface 1010b of the rear case may include fourth coupling holes 1011b, 1012b, 1013b, and 1014b. The third coupling holes 1015b and 1016b may be holes into which the first screws are inserted. In addition, the fourth coupling holes 1011b, 1012b, 1013b, and 1014b may be spaces into which the second screws are inserted.

According to an embodiment, the front surface 1010b of the rear case may be stacked to face the printed circuit board 1010a. Accordingly, the second screw may be inserted into the fourth coupling hole 1011b and the second coupling hole 1011a included in the bracket in a state in which the fourth and second coupling holes face each other.

Image (c) of FIG. 10 may be a view illustrating the rear surface 1010c of the rear case. According to an embodiment, the rear surface 1010c of the rear case may include a second heat dissipation portion 1020c (e.g., the second heat dissipation portion 411b in FIG. 4). The second heat dissipation portion 1020c may be included in a heat dissipation member and may be a heat dissipation structure plated in at least one partial area of the rear surface 1010c of the rear case through LMA plating.

According to an embodiment, the rear case may include third coupling holes 1015c and 1016c (e.g., the third coupling holes 1015b and 1016b in image (b) of FIG. 10) corresponding to the first coupling holes 1015a and 1016a and fourth coupling holes 1011c, 1012c, 1013c, and 1014c (e.g., the fourth coupling holes 1011b, 1012b, 1013b, and 1014b) corresponding to the second coupling holes 1011a, 1012a, 1013a, and 1014a.

According to an embodiment, the second heat dissipation portion 1020c may include at least some of the third coupling holes 1015c and 1016c and the fourth coupling holes 1011c, 1012c, 1013c, and 1014c. For example, the second heat dissipation portion 1020c may include at least some 1015c and 1016c of the third coupling holes and at least some 1013c and 1014c of the fourth coupling holes.

According to an embodiment, the third coupling holes 1015c and 1016c may be holes into which the first screws are inserted. For example, in a state in which the rear case is stacked on the top surface of the bracket, the first screws may be inserted into the third coupling holes 1015c and 1016c and the first coupling holes 1015a and 1016a. For example, as the first screws made of a heat conductor are inserted into the first coupling holes 1015a and 1016a and the third coupling holes 1015c and 1016c, the bracket, the printed circuit board 1010a, and the rear case may be fixed to each other by the first screws.

According to an embodiment, when thermal energy is generated from an electronic component mounted on the printed circuit board 1010a, the thermal energy may be dissipated through the first heat dissipating portion 1020b and may be transferred to the bracket and the heat dissipation members plated on the rear case via the first screws to be dissipated. For example, the thermal energy may be transferred to the second heat dissipation portion 1020c via the first screws to be dissipated.

According to an embodiment, the fourth coupling holes 1011c, 1012c, 1013c, and 1014c may be holes into which the second screws are inserted. For example, in a state in which the rear case is stacked on the top surface of the bracket, the second screws may be inserted into the fourth coupling holes 1011c, 1012c, 1013c, and 1014c and the second coupling holes 1011a, 1012a, 1013a, and 1014a. For example, the second screws may fix the rear case to the bracket.

According to an embodiment, when thermal energy is generated from an electronic component mounted on the printed circuit board 1010a from which the corners are removed, the thermal energy may be transferred to the bracket while being dissipated via the first heat dissipation portion 1020b. The thermal energy transferred to the bracket may be transferred to the rear case via the second screws, and may be dissipated through the heat dissipation members included in the rear case.

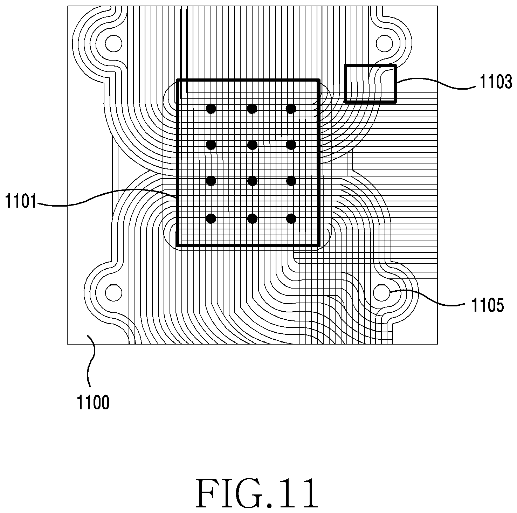

FIG. 11 is a view illustrating a heat dissipation pattern provided on a surface of a heat dissipation member according to an embodiment.

Referring to FIG. 11, a heat dissipation member 1100 may include a via hole area 1101, a heat dissipation pattern 1103, and coupling holes 1105.

According to an embodiment, an electronic device (e.g., the electronic device 100 in FIG. 1) may include a first plate (e.g., the front surface plate 102 in FIG. 1), a second plate (e.g., the rear surface plate 111 in FIG. 2), and a housing (e.g., the housing 110 in FIG. 1) including an inner space defined by a side surface member (e.g., the side surface member 118 of FIG. 1) substantially perpendicular to the first plate and the second plate. A rear case may be included in the housing.

According to an embodiment, the rear case may include the heat dissipation member 1100. The heat dissipation member 1100 may be provided in a partial area of each of the front and rear surfaces of the rear case through laser manufacturing antenna (LMA) plating. The heat dissipation member 1100 may be configured to dissipate heat energy generated from an electronic component mounted in the housing to an external low-temperature area.

According to an embodiment, the heat dissipation member 1100 may include the via hole area 1101 in at least one partial area. The via hole area 1101 is an area including one or more via holes, and the one or more via holes may be arranged at a predetermined interval. The via holes may be passages through which heat energy is dissipated from the front surface to the rear surface of the rear case. The heat dissipation member 1100 may be plated on the inner surfaces of the via holes. For example, the via holes may be holes that penetrate the front and rear surfaces of the rear case, and may configure a portion of the via hole area 1101 corresponding to the electronic component generating the thermal energy.

According to an embodiment, the heat dissipation member 1100 may include the heat dissipation pattern 1103. The heat dissipation pattern 1103 is a pattern provided on the surface of the heat dissipation member 1100 and may be a pattern that gives directionality to thermal energy. The heat dissipation pattern 1103 may be a combination of straight lines and/or curved lines. The heat dissipation pattern 1100 may be a pattern configured to dissipate heat energy generated from an electronic component mounted in the housing to an external low-temperature area. For example, the heat dissipation pattern may have a shape configured to dissipate the thermal energy to an area in which the side surface member is located.

According to an embodiment, the coupling holes 1105 may be holes into which screws corresponding to the standard of the coupling holes 1105 are inserted to couple the rear case on which the heat dissipation member 1100 is plated to at least one of the printed circuit board and the bracket. Like the above-described via holes, the coupling holes 1105 to which the screws are not coupled may serve as passages through which the thermal energy is dissipated to a low-temperature area.

Fig. 12 is a block diagram illustrating an electronic device 1201 in a network environment 1200 according to various embodiments.

Referring to Fig. 12, the electronic device 1201 in the network environment 1200 may communicate with an electronic device 1202 via a first network 1298 (e.g., a short-range wireless communication network), or at least one of an electronic device 1204 or a server 1208 via a second network 1299 (e.g., a long-range wireless communication network). According to an embodiment, the electronic device 1201 may communicate with the electronic device 1204 via the server 1208. According to an embodiment, the electronic device 1201 may include a processor 1220, memory 1230, an input module 1250, a sound output module 1255, a display module 1260, an audio module 1270, a sensor module 1276, an interface 1277, a connecting terminal 1278, a haptic module 1279, a camera module 1280, a power management module 1288, a battery 1289, a communication module 1290, a subscriber identification module (SIM) 1296, or an antenna module 1297. In some embodiments, at least one of the components (e.g., the connecting terminal 1278) may be omitted from the electronic device 1201, or one or more other components may be added in the electronic device 1201. In some embodiments, some of the components (e.g., the sensor module 1276, the camera module 1280, or the antenna module 1297) may be implemented as a single component (e.g., the display module 1260).

The processor 1220 may execute, for example, software (e.g., a program 1240) to control at least one other component (e.g., a hardware or software component) of the electronic device 1201 coupled with the processor 1220, and may perform various data processing or computation. According to an embodiment, as at least part of the data processing or computation, the processor 1220 may store a command or data received from another component (e.g., the sensor module 1276 or the communication module 1290) in volatile memory 1232, process the command or the data stored in the volatile memory 1232, and store resulting data in non-volatile memory 1234. According to an embodiment, the processor 1220 may include a main processor 1221 (e.g., a central processing unit (CPU) or an application processor (AP)), or an auxiliary processor 1223 (e.g., a graphics processing unit (GPU), a neural processing unit (NPU), an image signal processor (ISP), a sensor hub processor, or a communication processor (CP)) that is operable independently from, or in conjunction with, the main processor 1221. For example, when the electronic device 1201 includes the main processor 1221 and the auxiliary processor 1223, the auxiliary processor 1223 may be adapted to consume less power than the main processor 1221, or to be specific to a specified function. The auxiliary processor 1223 may be implemented as separate from, or as part of the main processor 1221.

The auxiliary processor 1223 may control at least some of functions or states related to at least one component (e.g., the display module 1260, the sensor module 1276, or the communication module 1290) among the components of the electronic device 1201, instead of the main processor 1221 while the main processor 1221 is in an inactive (e.g., sleep) state, or together with the main processor 1221 while the main processor 1221 is in an active state (e.g., executing an application). According to an embodiment, the auxiliary processor 1223 (e.g., an image signal processor or a communication processor) may be implemented as part of another component (e.g., the camera module 1280 or the communication module 1290) functionally related to the auxiliary processor 1223.

According to an embodiment, the auxiliary processor 1223 (e.g., the neural processing unit) may include a hardware structure specified for artificial intelligence model processing. An artificial intelligence model may be generated by machine learning. Such learning may be performed, e.g., by the electronic device 1201 in which the artificial intelligence is performed or via a separate server (e.g., the server 1208). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1230 may store various data used by at least one component (e.g., the processor 1220 or the sensor module 1276) of the electronic device 1201. The various data may include, for example, software (e.g., the program 1240) and input data or output data for a command related thereto. The memory 1230 may include the volatile memory 1232 or the non-volatile memory 1234.

The program 1240 may be stored in the memory 1230 as software, and may include, for example, an operating system (OS) 1242, middleware 1244, or an application 1246.

The input module 1250 may receive a command or data to be used by another component (e.g., the processor 1220) of the electronic device 1201, from the outside (e.g., a user) of the electronic device 1201. The input module 1250 may include, for example, a microphone, a mouse, a keyboard, a key (e.g., a button), or a digital pen (e.g., a stylus pen).

The sound output module 1255 may output sound signals to the outside of the electronic device 1201. The sound output module 1255 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1260 may visually provide information to the outside (e.g., a user) of the electronic device 1201. The display module 1260 may include, for example, a display, a hologram device, or a projector and control circuitry to control a corresponding one of the display, hologram device, and projector. According to an embodiment, the display module 1260 may include a touch sensor adapted to detect a touch, or a pressure sensor adapted to measure the intensity of force incurred by the touch.

The audio module 1270 may convert a sound into an electrical signal and vice versa. According to an embodiment, the audio module 1270 may obtain the sound via the input module 1250, or output the sound via the sound output module 1255 or a headphone of an external electronic device (e.g., an electronic device 1202) directly (e.g., wiredly) or wirelessly coupled with the electronic device 1201.

The sensor module 1276 may detect an operational state (e.g., power or temperature) of the electronic device 1201 or an environmental state (e.g., a state of a user) external to the electronic device 1201, and then generate an electrical signal or data value corresponding to the detected state. According to an embodiment, the sensor module 1276 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1277 may support one or more specified protocols to be used for the electronic device 1201 to be coupled with the external electronic device (e.g., the electronic device 1202) directly (e.g., wiredly) or wirelessly. According to an embodiment, the interface 1277 may include, for example, a high definition multimedia interface (HDMI), a universal serial bus (USB) interface, a secure digital (SD) card interface, or an audio interface.

A connecting terminal 1278 may include a connector via which the electronic device 1201 may be physically connected with the external electronic device (e.g., the electronic device 1202). According to an embodiment, the connecting terminal 1278 may include, for example, a HDMI connector, a USB connector, a SD card connector, or an audio connector (e.g., a headphone connector).

The haptic module 1279 may convert an electrical signal into a mechanical stimulus (e.g., a vibration or a movement) or electrical stimulus which may be recognized by a user via his tactile sensation or kinesthetic sensation. According to an embodiment, the haptic module 1279 may include, for example, a motor, a piezoelectric element, or an electric stimulator.

The camera module 1280 may capture a still image or moving images. According to an embodiment, the camera module 1280 may include one or more lenses, image sensors, image signal processors, or flashes.

The power management module 1288 may manage power supplied to the electronic device 1201. According to an embodiment, the power management module 1288 may be implemented as at least part of, for example, a power management integrated circuit (PMIC).

The battery 1289 may supply power to at least one component of the electronic device 1201. According to an embodiment, the battery 1289 may include, for example, a primary cell which is not rechargeable, a secondary cell which is rechargeable, or a fuel cell.

The communication module 1290 may support establishing a direct (e.g., wired) communication channel or a wireless communication channel between the electronic device 1201 and the external electronic device (e.g., the electronic device 1202, the electronic device 1204, or the server 1208) and performing communication via the established communication channel. The communication module 1290 may include one or more communication processors that are operable independently from the processor 1220 (e.g., the application processor (AP)) and support a direct (e.g., wired) communication or a wireless communication. According to an embodiment, the communication module 1290 may include a wireless communication module 1292 (e.g., a cellular communication module, a short-range wireless communication module, or a global navigation satellite system (GNSS) communication module) or a wired communication module 1294 (e.g., a local area network (LAN) communication module or a power line communication (PLC) module). A corresponding one of these communication modules may communicate with the external electronic device via the first network 1298 (e.g., a short-range communication network, such as BluetoothTM, wireless-fidelity (Wi-Fi) direct, or infrared data association (IrDA)) or the second network 1299 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1292 may identify and authenticate the electronic device 1201 in a communication network, such as the first network 1298 or the second network 1299, using subscriber information (e.g., international mobile subscriber identity (IMSI)) stored in the subscriber identification module 1296.

The wireless communication module 1292 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1292 may support a high-frequency band (e.g., the mmWave band) to achieve, e.g., a high data transmission rate. The wireless communication module 1292 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1292 may support various requirements specified in the electronic device 1201, an external electronic device (e.g., the electronic device 1204), or a network system (e.g., the second network 1299). According to an embodiment, the wireless communication module 1292 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1297 may transmit or receive a signal or power to or from the outside (e.g., the external electronic device) of the electronic device 1201. According to an embodiment, the antenna module 1297 may include an antenna including a radiating element composed of a conductive material or a conductive pattern formed in or on a substrate (e.g., a printed circuit board (PCB)). According to an embodiment, the antenna module 1297 may include a plurality of antennas (e.g., array antennas). In such a case, at least one antenna appropriate for a communication scheme used in the communication network, such as the first network 1298 or the second network 1299, may be selected, for example, by the communication module 1290 (e.g., the wireless communication module 1292) from the plurality of antennas. The signal or the power may then be transmitted or received between the communication module 1290 and the external electronic device via the selected at least one antenna. According to an embodiment, another component (e.g., a radio frequency integrated circuit (RFIC)) other than the radiating element may be additionally formed as part of the antenna module 1297.

According to various embodiments, the antenna module 1297 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1201 and the external electronic device 1204 via the server 1208 coupled with the second network 1299. Each of the electronic devices 1202 or 1204 may be a device of a same type as, or a different type, from the electronic device 1201. According to an embodiment, all or some of operations to be executed at the electronic device 1201 may be executed at one or more of the external electronic devices 1202, 1204, or 1208. For example, if the electronic device 1201 should perform a function or a service automatically, or in response to a request from a user or another device, the electronic device 1201, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1201. The electronic device 1201 may provide the outcome, with or without further processing of the outcome, as at least part of a reply to the request. To that end, a cloud computing, distributed computing, mobile edge computing (MEC), or client-server computing technology may be used, for example. The electronic device 1201 may provide ultra low-latency services using, e.g., distributed computing or mobile edge computing. In another embodiment, the external electronic device 1204 may include an internet-of-things (IoT) device. The server 1208 may be an intelligent server using machine learning and/or a neural network. According to an embodiment, the external electronic device 1204 or the server 1208 may be included in the second network 1299. The electronic device 1201 may be applied to intelligent services (e.g., smart home, smart city, smart car, or healthcare) based on 5G communication technology or IoT-related technology.

According to various embodiments, an electronic device (e.g., the electronic device 100 in FIG. 1) may include a first plate (e.g., the front surface plate 102) facing a first direction, a second plate (e.g., the rear surface plate 111 in FIG. 2) facing a second direction opposite to the first direction, a housing (e.g., the housing 110 in FIG. 1) including an inner space defined by a side surface member (e.g., the side surface member 118 in FIG. 1) substantially perpendicular to the first plate 102 and the second plate 111, a printed circuit board (e.g., the printed circuit board 340 in FIG. 3) disposed in the inner space, an electronic component mounted on the printed circuit board 340, and a rear case (e.g., the second support member 360 in FIG. 3) coupled along the side surface member 118 and including heat dissipation members (e.g., the first heat dissipation portion 411a and the second heat dissipation portion 411b in FIG. 4) in a partial area thereof. The heat dissipation members 411a and 411b may include a first heat dissipation portion 411a plated on the front surface of the rear case 360 corresponding to the top surface of the electronic component and including a first portion (e.g., the first portions 411a, 413a, and 414a in FIG. 4) extending in a direction in which the side surface member 118 is located, a second heat dissipation portion 411b plated on the rear surface of the rear case 360 and including a second portion (e.g., the second portions 412b, 413b, and 414b) extending in the direction in which the side surface member 118 is located, a via hole (e.g., the via hole 613 in FIG. 6) penetrating the first heat dissipation portion 411a and the second heat dissipation portion 411b, and an edge heat dissipation portion (e.g., the edge heat dissipation portions 416a and 416b in FIG. 4) plated in a partial area of a periphery interconnecting the front surface and the rear surface of the rear case 360 to interconnect the first heat dissipation portion 411a and the second heat dissipation portion 411b as one body.

According to various embodiments, the heat dissipation members (the first heat dissipation portion 411a and the second heat dissipation portion 411b ) may be provided by applying laser manufacturing antenna (LMA) plating to at least one partial area of the rear case 360.

According to various embodiments, the heat dissipation members 411a and 411b may include a hatched area provided in at least one partial area of the rear case 360 by using an ultraviolet ray (UV) laser or a fiber laser.

According to various embodiments, the heat dissipation members 411a and 411b may be configured to diffuse thermal energy generated from the electronic component from the first heat dissipation portion 411a to the second heat dissipation portion 411b.

According to various embodiments, the heat dissipation member 411a and 411b may include: a first section (e.g., the first section 510 in FIG. 5) and a fourth section (e.g., the fourth section 570 in FIG. 5) which are made of the same material, and a second section (e.g., the second section 530 in FIG. 5 ) and a third section (e.g., the third section 550 in FIG. 5) which are located between the first section 510 and the fourth section 570 and made of different materials, and the second section 530 may have a thickness smaller than that of the third section 550.

According to various embodiments, the via hole 613 may be located in an area corresponding to a hot spot area occurring based on thermal energy generated from the electronic component to dissipate the thermal energy from the front surface of the rear case 360 to the rear surface of the rear case 360.

According to various embodiments, the edge heat dissipation portions 416a and 416b may be configured to dissipate heat energy absorbed via the first heat dissipation portion 411a to the second heat dissipation portion 411b and to dissipate the heat energy in the horizontal direction of the electronic device 100.

According to various embodiments, the electronic device 100 may further include a camera module (e.g., the camera modules 105, 112, and 113 of FIG. 1), and the heat dissipation members 411a and 411b may be provided by being plated around an area in which the camera modules 105, 112, and 113 are mounted.

According to various embodiments, the electronic device may further include a bracket (e.g., the bracket 910 in FIG. 9) including first coupling holes (e.g., the first coupling holes 1015a and 1016a in FIG. 10) and second coupling holes (e.g., the second coupling holes 1011a, 1012a, 1013a, and 1014a in FIG. 10). The printed circuit board 340 may be placed on the top surface of the bracket 910 in a state in which an edge thereof is partially removed, and when the first screws are inserted through corners of the rear case 360, the first coupling holes 1015 and 1016 connect and fix the rear case 360 to the bracket 910 via the first screws.

According to various embodiments, when the second screws are inserted through the rear case 360, the second coupling holes 1011a, 1012a, 1013a, and 1014a may connect and fix the printed circuit board 340 disposed on the top surface of the bracket 910 and the rear case 360 to the bracket 910 via the second screws.

According to various embodiments, an electronic device 100 may include a first plate 102 facing a first direction, a second plate 111 facing a second direction opposite to the first direction, a housing 110 including an inner space defined by a side surface member 118 substantially perpendicular to the first plate 102 and the second plate 111, a printed circuit board 340 disposed in the inner space, an electronic component mounted on the printed circuit board 340, and a rear case 360 coupled along the side surface member 118 and including heat dissipation members 411a and 411b plated in a partial area. The heat dissipation members 411a and 411b may include a first heat dissipation portion 411a plated in a second area (e.g., the second area 360b in FIG. 3) included in a first area (e.g., the first area 360a in FIG. 3) corresponding to the top surface of the electronic component and including first portions 412a, 413a, and 414a extending from the second area 360b in a direction in which the side surface member 118 is located, a second heat dissipation portion 411b plated in a third area (e.g., the third area 403 in FIG. 4 ) of the rear surface of the rear case 360 and including second portions 412b, 413b, and 414b extending from the third area 403 in the direction in which the side surface member 118 is located, a via hole 613 penetrating the first heat dissipation portion 411a and the second heat dissipation portion 411b, edge heat dissipation portions 416a and 416b plated in a partial area of a periphery interconnecting the front surface and the rear surface of the rear case 360 to interconnect the first heat dissipation portion 411a and the second heat dissipation portion 411b as one body, and a heat dissipation pattern (e.g., the heat dissipation pattern 1103 in FIG. 11) provided on the surfaces of the first heat dissipation portion 411a and the second heat dissipation portion 411b to dissipate thermal energy generated from the electronic component to a specific direction.

According to various embodiments, the heat dissipation members 411a and 411b may be provided by applying laser manufacturing antenna (LMA) plating to at least one partial area of the rear case 360.

According to various embodiments, the heat dissipation members 411a and 411b may include a hatched area provided in at least one partial area of the rear case 360 by using an ultraviolet ray (UV) laser or a fiber laser.

According to various embodiments, the heat dissipation members 411a and 411b may be configured to diffuse thermal energy generated from the electronic component from the first heat dissipation portion 411a to the second heat dissipation portion 411b.

According to various embodiments, the heat dissipation members 411a and 411b may include a first section 510 and a fourth section 570 which are made of a same material, and a second section 530 and a third section 550 which are located between the first section 510 and the fourth section 570 and made of different materials, and the second section 530 may have a thickness smaller than that of the third section 550.

According to various embodiments, the via hole 613 may be located in an area corresponding to a hot spot area occurring based on thermal energy generated from the electronic component to dissipate the thermal energy from the front surface of the rear case 360 to the rear surface of the rear case 360.

According to various embodiments, the edge heat dissipation portions 416a and 416b may be configured to dissipate heat energy absorbed via the first heat dissipation portion 411a to the second heat dissipation portion 411b and to dissipate the heat energy in the horizontal direction of the electronic device 100.

According to various embodiments, the electronic device 100 may further include camera modules 105, 112, and 113, and the heat dissipation members 411a and 411b may be provided by being plated around an area in which the camera modules 105, 112, and 113 are mounted.

According to various embodiments, the electronic device may further include a bracket 910 provided with first coupling holes 1015a and 1016a and second coupling holes 1011a, 1012a, 1013a, and 1014a, the printed circuit board 340 may be placed on the top surface of the bracket 340 in a state in which an edge thereof is partially removed, and when the first screws are inserted through corners of the rear case 360, the first coupling holes 1015 and 1016 connect and fix the rear case 360 to the bracket 390 via the first screws.

According to various embodiments, when the second screws are inserted through the rear case 360, the second coupling holes 1011a, 1012a, 1013a, and 1014a may connect and fix the printed circuit board 340 disposed on the top surface of the bracket 910 and the rear case 360 to the bracket 910 via the second screws.

In the specific embodiments of the present disclosure described above, elements included in the disclosure are expressed in singular or plural numbers according to the specific embodiments presented. However, singular or plural expressions are selected appropriately for the presented situation for convenience of explanation, and the present disclosure is not limited to singular or plural elements, and elements expressed in the plural number may be composed of a singular number, or even elements expressed in the singular number may be composed of a plurality.

Meanwhile, in the detailed description of the present disclosure, specific embodiments have been described, but various modifications are possible without departing from the scope of the present disclosure. Therefore, the scope of the present disclosure should not be limited to the described embodiments and should not be defined by the scope of the claims described below as well as those equivalent to the scope of these claims.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1240) including one or more instructions that are stored in a storage medium (e.g., internal memory 1236 or external memory 1238) that is readable by a machine (e.g., the electronic device 1201). For example, a processor (e.g., the processor 1220) of the machine (e.g., the electronic device 1201) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between in which data is semi-permanently stored in the storage medium and in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a first plate facing a first direction;
a second plate facing a second direction opposite to the first direction;
a housing comprising an inner space defined by a side surface member perpendicular to the first plate and the second plate;
a printed circuit board disposed in the inner space;
an electronic component mounted on the printed circuit board; and
a rear case coupled along the side surface member and comprising a heat dissipation member in a partial area thereof,
wherein the heat dissipation member comprises:
a first heat dissipation portion plated on a front surface of the rear case corresponding to a top surface of the electronic component and comprising a first portion extending in a direction in which the side surface member is located;
a second heat dissipation portion plated on a rear surface of the rear case and comprising a second portion extending in the direction in which the side surface member is located;
a via hole penetrating the first heat dissipation portion and the second heat dissipation portion; and
an edge heat dissipation portion plated in a partial area of a periphery interconnecting the front surface and the rear surface of the rear case to interconnect the first heat dissipation portion and the second heat dissipation portion as one body.

2. The electronic device of claim 1, wherein the heat dissipation member is provided by applying laser manufacturing antenna, LMA, plating to at least one partial area of the rear case.

3. The electronic device of claim 2, wherein the heat dissipation member comprises a hatched area provided in at least one partial area of the rear case by using an ultraviolet ray, UV, laser or a fiber laser.

4. The electronic device of claim 1, wherein the heat dissipation member is configured to diffuse thermal energy generated from the electronic component from the first heat dissipation portion to the second heat dissipation portion.

5. The electronic device of claim 1, wherein the heat dissipation member comprises:
a first section and a fourth section which are made of a same material; and
a second section and a third section which are located between the first section and the fourth section and made of different materials, and
wherein the second section has a thickness smaller than that of the third section.

6. The electronic device of claim 1, wherein the via hole is located in an area corresponding to a hot spot area occurring based on thermal energy generated from the electronic component to dissipate the thermal energy from a front surface of the rear case to a rear surface of the rear case.

7. The electronic device of claim 1, wherein the edge heat dissipation portion is configured to dissipate heat energy absorbed via the first heat dissipation portion to the second heat dissipation portion and to dissipate the thermal energy in a horizontal direction of the electronic device.

8. The electronic device of claim 1, further comprising a camera module, wherein the heat dissipation member is provided by being plated around an area in which the camera module is mounted.

9. The electronic device of claim 1, further comprising a bracket including a first coupling hole and a second coupling hole,
wherein the printed circuit board is placed on a top surface of the bracket in a state in which an edge thereof is partially removed, and
in case that a first screw is inserted through a corner of the rear case, the first coupling hole connects and fixes the rear case to the bracket via the first screw.

10. The electronic device of claim 9, wherein, in case that the second screw is inserted through the rear case, the second coupling hole connects and fixes the printed circuit board and the rear case disposed on the top surface of the bracket to the bracket via the second screw.

11. An electronic device comprising:
a first plate facing a first direction;
a second plate facing a second direction opposite to the first direction;
a housing comprising an inner space defined by a side surface member perpendicular to the first plate and the second plate;
a printed circuit board disposed in the inner space;
an electronic component mounted on the printed circuit board; and
a rear case coupled along the side surface member and comprising a heat dissipation member plated in a partial area thereof,
wherein the heat dissipation member comprises:
a first heat dissipation portion plated in a second area included in a first area corresponding to a top surface of the electronic component and comprising a first portion extending from the second area in a direction in which the side surface member is located;
a second heat dissipation portion plated in a third area of the rear surface of the rear case and comprising a second portion extending from the third area in the direction in which the side surface member is located;
a via hole penetrating the first heat dissipation portion and the second heat dissipation portion;
an edge heat dissipation portion plated in a partial area of a periphery interconnecting the front surface and the rear surface of the rear case to interconnect the first heat dissipation portion and the second heat dissipation portion as one body; and
a heat dissipation pattern provided on surfaces of the first heat dissipation portion and the second heat dissipation portion to dissipate thermal energy generated from the electronic component to a predetermined direction.

12. The electronic device of claim 11, wherein the heat dissipation member is provided by applying laser manufacturing antenna, LMA, plating to at least one partial area of the rear case.

13. The electronic device of claim 12, wherein the heat dissipation member comprises a hatched area provided in at least one partial area of the rear case by using an ultraviolet ray, UV, laser or a fiber laser.

14. The electronic device of claim 11, wherein the heat dissipation member is configured to diffuse thermal energy generated from the electronic component from the first heat dissipation portion to the second heat dissipation portion.

15. The electronic device of claim 11, wherein the heat dissipation member comprises:
a first section and a fourth section which are made of a same material; and
a second section and a third section which are located between the first section and the fourth section and made of different materials, and
wherein the second section has a thickness smaller than that of the third section.
